# EUROPÄISCHE PATENTSCHRIFT

(11) **EP 3 898 150 B1**
(45) Veröffentlichungstag und Bekanntmachung des Hinweises auf die Patenterteilung: **10.04.2024**
(21) Anmeldenummer: 19828238.6
(22) Anmeldetag: 12.12.2019
(51) Int. Cl.: B28D 5/00, B28D 5/04, B23D 59/00, H01L 21/02

(54) **VERFAHREN ZUR HERSTELLUNG VON HALBLEITERSCHEIBEN MITTELS EINER DRAHTSÄGE, DRAHTSÄGE UND HALBLEITERSCHEIBE AUS EINKRISTALLINEM SILIZIUM**
METHOD FOR PRODUCING SEMICONDUCTOR WAFERS USING A WIRE SAW, WIRE SAW, AND SEMICONDUCTOR WAFERS MADE OF MONOCRYSTALLINE SILICON
PROCÉDÉ DE FABRICATION DE TRANCHES DE SEMI-CONDUCTEUR AU MOYEN D'UNE SCIE À FIL, SCIE À FIL ET TRANCHE DE SEMI-CONDUCTEUR EN SILICIUM MONOCRISTALLIN

(30) Priorität: 17.12.2018 DE 102018221922
(43) Veröffentlichungstag der Anmeldung: 27.10.2021
(60) Teilanmeldung: 23210279.8
(73) Patentinhaber: Siltronic AG, 81677 München (DE)
(72) Erfinder: BEYER, Axel, 80538 München (DE); WELSCH, Stefan, 84570 Polling (DE)
(74) Vertreter: Staudacher, Wolfgang
(86) Internationale Anmeldenummer: PCT/EP2019/084802
(87) Internationale Veröffentlichungsnummer: WO 2020/126787

(56) Entgegenhaltungen:
- DE-T5-112016 005 417
- JP-A- H11 165 251
- US-A1- 2008 166 948
- US-A1- 2015 004 799

## Beschreibung

Gegenstand der Erfindung ist ein Verfahren, gemäß dem Oberbegriff des Patentanspruchs 1, zur Herstellung von Halbleiterscheiben aus einem Werkstück durch Bearbeiten des Werkstücks mittels einer Drahtsäge und eine Drahtsäge, gemäß dem Oberbegriff des Patentanspruchs 8, zur Durchführung des Verfahrens.

### Stand der Technik / Probleme

In WO 2015/188 859 A1 sind eine Drahtsäge und deren Funktionsprinzip ausführlich dargestellt.

Aus JP 09 109 143 A ist ein Verfahren zur Herstellung von Scheiben (wafers) aus einem Werkstück (ingot) mittels einer Drahtsäge bekannt, das folgende Schritte umfasst: das Detektieren der Position von Drähten eines Drahtfelds der Drahtsäge und beim Vorliegen einer Auslenkung der Drähte das Herbeiführen einer Ausgleichsbewegung einer Drahtführungsrolle zur Korrektur der Auslenkung.

Aus der JP H11 165251 A, die ein Verfahren gemäß dem Oberbegriff des Anspruchs 1 und eine Drahtsäge gemäß dem Oberbegriff des Anspruchs 8 offenbart, ist ein ähnliches Verfahren bekannt, das folgende Schritte umfasst: das Detektieren der Position von Drähten eines Drahtfelds der Drahtsäge und beim Vorliegen einer Auslenkung der Drähte das Herbeiführen einer Ausgleichsbewegung des Werkstücks.

Aus US 5 875 770 ist ein ähnliches Verfahren bekannt, das folgende Schritte umfasst: das Detektieren des warp von Scheiben vor der Bearbeitung des Werkstücks und das Herbeiführen einer Ausgleichsbewegung des Werkstücks entlang einer axialen Richtung des Werkstücks in einem Umfang, dass Scheiben mit reduziertem warp entstehen.

Aus JP 2009 61 527 A ist ein ähnliches Verfahren bekannt, das dem Umstand, dass sich das Werkstück auf Grund von Wärmeausdehnung axial bewegen kann, Rechnung trägt, indem Mittel vorgesehen sind, den Drahtführungsrollen eine kompensierende Bewegung zu ermöglichen.

Ungeachtet dieser zur Verfügung stehenden Lösungen besteht weiterhin Bedarf an einer Verbesserung des Verfahrens zur Herstellung von Halbleiterscheiben aus einem Werkstück mittels einer Drahtsäge. Insbesondere ist zu berücksichtigen, dass die axiale Bewegung des Werkstücks auf Grund von Wärmeausdehnung nur näherungsweise durch eine entsprechende axiale Bewegung der Drahtführungsrollen ausgeglichen werden kann. Darüber hinaus ist eine Regelung der axialen Positionen der Drähte über die Temperatur der Drahtführungsrollen vergleichsweise träge. Ferner kann der gemessene warp von Scheiben aus einem vorher bearbeiteten Werkstück nur näherungsweise Abweichungen für ein noch zu bearbeitendes Werkstück beschreiben und die axiale Bewegung eines gesamten Werkstücks solche Abweichungen nur teilweise kompensieren.

Notwendig ist insbesondere eine Verbesserung des Verfahrens, damit Halbleiterscheiben zugänglich werden, deren Ebenheit insbesondere hinsichtlich warp und Nanotopographie besser ist, als diejenige von Scheiben, die in bekannter Weise hergestellt werden.

Aus der beschriebenen Problematik ergab sich die Aufgabenstellung der Erfindung.

Die Aufgabe der Erfindung wird gelöst durch ein Verfahren zur Herstellung von Halbleiterscheiben aus einem Werkstück durch Bearbeiten des Werkstücks mittels einer Drahtsäge, umfassend
das Zustellen des Werkstücks durch eine Anordnung von Drähten, die in Drahtgruppen gegliedert zwischen Drahtführungsrollen gespannt sind und sich in eine Laufrichtung bewegen;
das Erzeugen von Schnittspalten beim Eingriff der Drähte in das Werkstück;
für jede der Drahtgruppen das Ermitteln einer Fehllage der Schnittspalte der Drahtgruppe; und
für jede der Drahtgruppen das Herbeiführen von Ausgleichsbewegungen der Drähte der Drahtgruppe in Abhängigkeit der ermittelten Fehllage der Schnittspalte der Drahtgruppe in eine Richtung senkrecht zur Laufrichtung der Drähte der Drahtgruppe während des Zustellens des Werkstücks durch die Anordnung von Drähten durch Aktivieren mindestens eines Antriebselements.

Es sind mindestens zwei Drahtgruppen vorgesehen, vorzugsweise mindestens drei Drahtgruppen und besonders bevorzugt vier Drahtgruppen, aber es ist auch möglich, dass jeder Draht als eigene Drahtgruppe aufgefasst wird, also die Anzahl der Drahtgruppen der Anzahl der Drähte der Anordnung von Drähten (Drahtgatter) entspricht. Drahtgruppen haben vorzugsweise dieselbe axiale Breite und der Abstand zwischen benachbarten Drähten einer Drahtgruppe ist derselbe.

Erfindungsgemäß werden, für jede der Drahtgruppen gesondert, Ausgleichsbewegungen der Drähte der Drahtgruppe in eine Richtung senkrecht zur Laufrichtung der Drähte der Drahtgruppe, also in Richtung der Drehachsen der Drahtführungsrollen, herbeigeführt. Zu diesem Zweck wird mindestens ein Antriebselement aktiviert, das die Drähte in die vorgesehene Richtung und über die vorgesehene Strecke verschiebt. Die Ausgleichsbewegungen der Drähte der Drahtgruppe werden unabhängig von einem gegebenenfalls gleichzeitig erfolgenden Herbeiführen von Ausgleichsbewegungen der Drähte einer anderen Drahtgruppe herbeigeführt.

Als Antriebselement kommen insbesondere elektromagnetische, mechanische, hydraulische, pneumatische, magnetostriktive und vorzugsweise piezoelektrische Aktoren in Betracht. Sind die Drähte beispielsweise in vier Drahtgruppen gegliedert, bilden die Drahtgruppen zwei innere und zwei äußere Drahtgruppen. Dehnt sich das Werkstück auf Grund von Wärme aus, ist die Fehllage eines Schnittspalts, der einem Draht einer der inneren Drahtgruppen zuzuordnen ist geringer als diejenige, die einem Draht einer der äußeren Drahtgruppen zuzuordnen ist. Dementsprechend müssen die Beträge der Ausgleichsbewegungen der Drähte der äußeren Drahtgruppen größer gewählt werden, als der Betrag der Ausgleichsbewegungen der Drähte der inneren Drahtgruppen. Im Fall, dass jeder Draht als eigene Drahtgruppe aufgefasst wird, wird jeder Draht einer Ausgleichsbewegung mit eigenem Betrag und eigener Richtung unterworfen.

Eine vom Werkstück abgetrennte Halbleiterscheibe hat eine obere und eine untere Seitenfläche und eine zwischen beiden verlaufende Kante. Üblicherweise wird angestrebt, dass die obere und untere Seitenfläche nach dem Abtrennen vom Werkstück möglichst eben sind und einen möglichst gleichmäßigen Abstand zueinander haben. Je besser die Ebenheit der Seitenflächen und die Gleichmäßigkeit der Dicke der Halbleiterscheibe anfänglich sind, desto eher gelingt es und desto geringer wird der Aufwand, die Halbleiterscheibe durch nachfolgende Schritte wie Läppen und/oder Schleifen, Ätzen, Polieren und gegebenenfalls Beschichten in ein Zielprodukt zu veredeln, das den strengen Anforderungen der Industrie genügt, die die Halbleiterscheibe zu elektronischen Bauelementen weiterverarbeitet. Die obere Seitenfläche wird auch als Vorderseite der Halbleiterscheibe bezeichnet und ist in der Regel diejenige Fläche, auf der oder in die im Zuge einer Weiterverarbeitung der Halbleiterscheibe beabsichtigt ist, Strukturen elektronischer Bauelemente unterzubringen.

Die vorliegende Erfindung verfolgt das Ziel, beim Bearbeiten des Werkstücks mittels einer Drahtsäge dafür zu sorgen, dass Schnittspalte im Werkstück entstehen, deren Lage möglichst geringfügig von einer als ideal angesehenen Lage abweicht. Werden Halbleiterscheiben mit einheitlicher Dicke und möglichst ebenen Seitenflächen angestrebt, verläuft ein idealer Schnittspalt geradlinig und rechtwinkelig zur Längsachse des Werkstücks. Mit anderen Worten ausgedrückt, die Trajektorie durch die Mitte eines solchen Schnittspalts läuft entlang einer Geraden, die senkrecht zur Längsachse des Werkstücks orientiert ist. Eine solche Trajektorie wird nachfolgend als angestrebte Trajektorie bezeichnet. Demnach liegt eine Fehllage eines Schnittspalts vor, wenn die tatsächliche Trajektorie von der angestrebten Trajektorie abweicht. Das ist dann der Fall, wenn ein Ortsvektor, der zur Mitte des Schnittspalts zeigt, nicht mehr auf der angestrebten Trajektorie endet.

Eine Fehllage eines Schnittspalts entsteht beispielsweise, wenn sich ein Draht während des Eingriffs in das Werkstück senkrecht zu seiner Laufrichtung, also in Richtung der Drehachsen der Drahtführungsrollen bewegt, zwischen denen er gespannt ist, oder wenn sich das Werkstück während des Zustellens durch die Anordnung von Drähten auf Grund von Wärmeentwicklung axial ausdehnt. Die Fehllage eines Schnittspalts ist im zuletzt genannten Fall umso größer, je mehr Abstand der Schnittspalt zur Mitte des Werkstücks hat. Die Mitte des Werkstücks ist der Ort zwischen den beiden Enden des Werkstücks.

Ein Aspekt der Erfindung ist, für jede Drahtgruppe gesondert, die Fehllage der Schnittspalte zu ermitteln, unabhängig davon, welche Ursache zu einer Relativbewegung zwischen Werkstück und Drahtgruppe geführt hat. Beispiele für solche Ursachen sind eine Bewegung der Drahtgruppe, eine Bewegung des Werkstücks oder eine thermische Ausdehnung des Werkstücks. Ein weiterer Aspekt der vorliegenden Erfindung ist, zu unterscheiden zwischen einer Fehllage der Schnittspalte, die systematisch bei Verwendung einer bestimmten Drahtsäge auftritt, und einer Fehllage der Schnittspalte, die zufällig und unabhängig von der Verwendung einer bestimmten Drahtsäge auftritt.

Zweckmäßigerweise wird, für jede der Drahtgruppen gesondert, mindestens ein geschlossener Regelkreis eingerichtet, in dem auf eine Regelabweichung, also auf eine ermittelte Fehllage der Schnittspalte der Drahtgruppe, mit einer Veränderung der Stellgröße, also dem Herbeiführen einer Ausgleichsbewegung der Drähte der Drahtgruppe reagiert wird.

Gemäß einer ersten Ausgestaltung des erfindungsgemäßen Verfahrens erfolgt das Ermitteln der Fehllage der Schnittspalte der Drahtgruppe, für jede Drahtgruppe gesondert, während des Zustellens des Werkstücks durch die Anordnung von Drähten. Gemäß einer ersten Alternative der ersten Ausgestaltung wird die Position vorzugsweise eines jeden Schnittspalts relativ zu einem feststehenden Bezugspunkt gemessen und mit einer Soll-Position verglichen. Die Soll-Position eines Schnittspalts ist die Position relativ zum feststehenden Bezugspunkt, die Voraussetzung wäre, damit ein idealer Schnittspalt entstehen kann. Die Abweichung der gemessenen Position des Schnittspalts von dessen Soll-Position entspricht der Fehllage des Schnittspalts. Da die Abweichung für jeden Schnittspalt der Drahtgruppe grundsätzlich unterschiedlich sind, werden die Abweichungen zu einer Fehllage gemittelt, die die Fehllage der Schnittspalte der Drahtgruppe repräsentiert. Mit anderen Worten, jedem Schnittspalt der Drahtgruppe wird die gleiche, gemittelte Fehllage zugeordnet. Die Mittelung kann ohne Gewichtung erfolgen oder Fehllagen bestimmter Schnittspalte werden besonders gewichtet. Aus der Fehllage der Schnittspalte der Drahtgruppe lässt sich ein Korrekturprofil ableiten, das vorgibt, mit welchem Betrag und in welche Richtung die Drähte der Drahtgruppe während des Zustellens des Werkstücks bewegt werden müssen, um die Fehllage der Schnittspalte zu beseitigen. Das Korrekturprofil hat, betrachtet über die Eindringtiefe der Drähte in das Werkstück, einen Verlauf, der komplementär zum Verlauf der ermittelten Fehllage der Schnittspalte der Drahtgruppe ist.

Das Messen der Position der Schnittspalte der Drahtgruppe erfolgt vorzugsweise mittels Bestrahlung der Schnittspalte der Drahtgruppe mit optischer Strahlung, IR-Strahlung, Röntgen-Strahlung oder γ-Strahlung. Darüber hinaus kommt auch eine mechanische Abtastung der Schnittspalte der Drahtgruppe oder eine induktive oder kapazitive Messung der Schnittspalte der Drahtgruppe in Betracht. Eine solche direkte Beobachtung der Schnittspalte der Drahtgruppe legt jede Relativbewegung zwischen dem Werkstück und den Drähten einer Drahtgruppe offen.

Gemäß einer zweiten Alternative der ersten Ausgestaltung wird die Position vorzugsweise eines jeden Drahts einer Drahtgruppe und des Werkstücks relativ zu einem feststehenden Bezugspunkt zeitgleich gemessen und mit einer Soll-Position verglichen, um eine solche Relativbewegung zu erfassen. Da die Abweichung für jeden Draht der Drahtgruppe grundsätzlich unterschiedlich ist, werden die Abweichungen zu einer Fehllage gemittelt, die die Fehllage der Drähte der Drahtgruppe repräsentiert. Mit anderen Worten, jedem Draht der Drahtgruppe wird die gleiche, gemittelte Fehllage zugeordnet. Die Mittelung kann ohne Gewichtung erfolgen oder Fehllagen bestimmter Schnittspalte werden besonders gewichtet. Die Soll-Position des Drahts ist die Position des Drahts relativ zum feststehenden Bezugspunkt, die Voraussetzung wäre, damit ein idealer Schnittspalt entstehen kann. Entsprechendes gilt für die Soll-Position des Werkstücks. Aus der Summe der gemessenen Abweichungen von den Soll-Positionen von Draht und Werkstück wird die Abweichung der tatsächlichen Trajektorie von der angestrebten Trajektorie näherungsweise bestimmt.

Das Messen der Position der Drähte der Drahtgruppe beziehungsweise der Position des Werkstücks erfolgt mittels Bestrahlung der Drähte der Drahtgruppe beziehungsweise des Werkstücks mit optischer Strahlung, IR-Strahlung, Röntgen-Strahlung oder γ-Strahlung, oder mittels kapazitiver oder induktiver Messung. Darüber hinaus kommt auch eine mechanische Abtastung der Drähte der Drahtgruppe beziehungsweise des Werkstücks oder eine induktive oder kapazitive Messung der Drähte der Drahtgruppe beziehungsweise des Werkstücks in Betracht. Die Position des Werkstücks kann relativ zu Stirnflächen des Werkstücks und vorzugsweise relativ zu auf dem Werkstück markierten Referenzpunkten ermittelt werden.

Gemäß einer zweiten Ausgestaltung des erfindungsgemäßen Verfahrens erfolgt das Ermitteln der Fehllage der Schnittspalte der Drahtgruppe, für jede Drahtgruppe gesondert, vor dem Zustellen des Werkstücks durch die Anordnung von Drähten. Aufgrund dieser Vorgehensweise wird eine Fehllage der Schnittspalte ermittelt, die systematisch bei Verwendung einer bestimmten Drahtsäge auftritt. Zum Ermitteln der Fehllage der Schnittspalte wird die lokale Geometrie von Halbleiterscheiben, die zuvor mittels einer bestimmten Drahtsäge hergestellt wurden, gemessen. Diese Halbleiterscheiben stammen von einem oder mehreren Werkstücken, die mittels dieser Drahtsäge hergestellt wurden und zwar mittels Drähten der Drahtgruppe, für die die Fehllage der Schnittspalte ermittelt wird. Die lokale Geometrie einer Halbleiterscheibe bildet näherungsweise die Trajektorie des der Halbleiterscheibe benachbarten Schnittspalts ab. Vorzugsweise wird die lokale Geometrie von der Medianfläche einer warp-Messung nach SEMI MF 1390-0218 abgeleitet und zwar wie folgt: eine Höhenlinie (line scan, LS) wird erzeugt durch Selektion derjenigen Messwerte der Medianfläche, welche sich auf einer Linie befinden, die durch das Zentrum der Halbleiterscheibe verläuft. Die Messwerte liegen auf einer Linie, die einem Durchmesser der Halbleiterscheibe vorzugsweise in Richtung des Zustellens des Werkstücks beim Abtrennen der Halbleiterscheibe folgt oder zumindest um nicht mehr als ± 20° von einer solchen Richtung abweicht.

Um eine Fehllage der Schnittspalte der Drahtgruppe zu erkennen, die systematisch beim Verwenden einer bestimmten Drahtsäge auftritt, wird die lokale Geometrie der Halbleiterscheiben, die von einem oder mehreren Werkstücken, die mittels dieser Drahtsäge hergestellt wurden, stammen und mittels Drähten der Drahtgruppe erzeugt wurden, zu einer einzigen lokalen Geometrie gemittelt. Die Mittelung kann ohne Gewichtung erfolgen oder die lokale Geometrie bestimmter Halbleiterscheiben wird auf Grund von deren relativen Lage im Werkstück besonders gewichtet. Ausgehend von der gemittelten lokalen Geometrie wird dann geschlossen, wie die Trajektorie des Schnittspalts sein wird, falls die bestimmte Drahtsäge verwendet wird und weitere Einflüsse, die sich auf die Trajektorie auswirken, außer Betracht bleiben. Eine solche Trajektorie wird nachfolgend die zu erwartende Trajektorie genannt. Die Fehllage der Schnittspalte der Drahtgruppe, mit der während des Zustellens des Werkstücks zu rechnen ist, ergibt sich aus dem Vergleich der zu erwartenden Trajektorie mit der anzustrebenden Trajektorie. Der Vergleich liefert ein drahtsägespezifisches Korrekturprofil, das Richtung und Betrag der Ausgleichsbewegungen der Drähte der Drahtgruppe in Abhängigkeit der Eindringtiefe der Drähte in das Werkstück während des Zustellens des Werkstücks durch die Anordnung von Drähten vorgibt. Der Verlauf des drahtsägespezifischen Korrekturprofils ist im Prinzip komplementär zum Verlauf der gemittelten lokalen Geometrie.

Das drahtsägespezifische Korrekturprofil wird vorzugsweise zusätzlich herangezogen, um frühzeitig Veränderungen des Leistungsverhaltens der Drahtsäge erkennen und darauf reagieren zu können. Veränderungen des drahtsägespezifischen Korrekturprofils, die im Verlauf der Bearbeitung von Werkstücken auftreten, weisen auf einen Verschleiß des Drahts und/oder des Belags der Drahtführungsrollen oder eines anderen, einem Verschleiß unterworfenen Bauteils der Drahtsäge hin. Es kann deshalb eine Schwelle für die Veränderung des drahtsägespezifischen Korrekturprofils definiert werden, bei deren Erreichen vorsorgliche Wartungsmaßnahmen (predictive maintenance) eingeleitet werden. Auch vor dem Erreichen einer solcher Schwelle können Veränderungen des drahtsägespezifischen Korrekturprofils zum Anlass genommen werden, um Anpassungsmaßnahmen vorzunehmen, die einer verschleißbedingten Verschlechterung des Arbeitsergebnisses entgegenwirken. Solche Anpassungsmaßnahmen können beispielsweise die Änderung der Zusammensetzung und/oder der Temperatur einer Schneidmittel-Suspension oder die Änderung der Temperatur eines Kühlmittels beinhalten, ebenso wie die Änderung der Drahtgeschwindigkeit oder anderer prozessspezifischer Parameter.

Eine dritte Ausgestaltung der Erfindung sieht vor, die erste und die zweite Ausgestaltung zu kombinieren. Ein erster Teil der Ausgleichsbewegungen der Drähte der Drahtgruppe wird auf der Grundlage eines Korrekturprofils herbeigeführt, das entsprechend der ersten Ausgestaltung der Erfindung in Echtzeit während des Zustellens des Werkstücks in Abhängigkeit der Eindringtiefe der Drähte der Drahtgruppe ermittelt wird. Ein weiterer Teil der Ausgleichsbewegungen der Drähte der Drahtgruppe wird auf der Grundlage eines drahtsägespezifischen Korrekturprofils herbeigeführt, das entsprechend der zweiten Ausgestaltung der Erfindung vor dem Zustellen des Werkstücks durch die Anordnung von Drähten für die jeweilige Drahtgruppe, ermittelt wurde. Damit werden Einflüsse auf die Fehllage der Schnittspalte, die zufällig auftreten und deshalb nicht vorhersehbar sind und solche, die wegen der Verwendung einer bestimmten Drahtsäge systematisch auftreten, voneinander entkoppelt berücksichtigt.

Ein drahtsägespezifisches Korrekturprofil kann selbstverständlich auch durch Aufzeichnen des Korrekturprofils erhalten werden, das gemäß der ersten Ausgestaltung des erfindungsgemäßen Verfahrens abgeleitet wird.

Die vorliegende Erfindung kann in Verbindung mit Drähten genutzt werden, die am Draht gebundenes Schneidkorn aufweisen, oder in Verbindung mit Drähten, die frei davon sind und ihre Wirkung in Kombination mit einer Schneidmittel-Suspension entfalten. Als gebundenes Schneidkorn kommt insbesondere Diamant in Frage. Die Drähte, von denen hier die Rede ist, sind Abschnitte eines Drahts, der um die Drahtführungsrollen der Drahtsäge gewickelt ist. Die Anzahl der Drahtführungsrollen der Drahtsäge ist nicht wesentlich für die Nutzung der Erfindung. Beispielsweise kann die Drahtsäge zwei, drei, vier oder eine noch höhere Anzahl von Drahtführungsrollen umfassen.

Das Werkstück besteht vorzugsweise aus einem Halbleitermaterial wie Silizium, das in multikristallinem oder einkristallinem Zustand vorliegen kann. Der Umfang des Werkstücks ist quadratisch, rechteckig oder kreisförmig. Das erfindungsgemäße Verfahren eignet sich insbesondere zur Herstellung von runden Halbleiterscheiben aus einkristallinem Silizium mit einem Durchmesser von mindestens 200 mm, insbesondere mindestens 300 mm.

Die Aufgabe der Erfindung wird des Weiteren gelöst durch eine Drahtsäge zur Herstellung von Halbleiterscheiben durch Bearbeiten eines Werkstücks, umfassend Drahtführungsrollen, zwischen denen Drähte zu einer Anordnung von Drähten gespannt sind, die in Drahtgruppen gegliedert sind und sich in eine Laufrichtung bewegen;
eine Einheit zum Zustellen des Werkstücks durch die Anordnung von Drähten unter Erzeugen von Schnittspalten beim Eingriff der Drähte in das Werkstück;
Antriebselemente, von denen mindestens eines einer jeden der Drahtgruppen zugeordnet ist, zum Bewegen der Drähte der zugeordneten Drahtgruppe; und
eine Steuerungseinheit zum Aktivieren der Antriebselemente, wobei die Steuerungseinheit beim Vorliegen einer Fehllage der Schnittspalte der Drahtgruppen dasjenige Antriebselement aktiviert, welches der Drahtgruppe zugeordnet ist, wodurch die Drähte dieser Drahtgruppe Ausgleichsbewegungen senkrecht zur Laufrichtung ausführen.

Die Drahtsäge umfasst eine Einheit zum Zustellen eines Werkstücks durch eine Anordnung von Drähten, die zwischen Drahtführungsrollen gespannt sind.

Die Drahtsäge kann zwei oder mehrere Drahtführungsrollen umfassen, um die Sägedraht gewickelt ist. Bei einer erfindungsgemäßen Drahtsäge sind die Drähte in Drahtgruppen gegliedert, und mindestens ein Antriebselement ist jeder der Drahtgruppen zugeordnet. Beim Aktivieren eines Antriebselements werden die Drähte der ihm zugeordneten Drahtgruppe senkrecht zur Laufrichtung der Drähte bewegt, also in Richtung der Drehachsen der Drahtführungsrollen. Das aktivierte Antriebselement bewegt die Drähte der ihm zugeordneten Drahtgruppe gleichzeitig mit demselben Betrag in die dieselbe Richtung. Wegen der Zuordnung der Antriebselemente sind der Betrag und die Richtung der Bewegung der Drähte einer Drahtgruppe unabhängig vom Betrag und der Richtung der Bewegung der Drähte einer anderen Drahtgruppe. Die Drahtführungsrollen, zwischen denen die zu Drahtgruppen gegliederten Drähte gespannt sind, so dass sie die Anordnung von Drähten bilden, sind mit den Antriebselementen versehen. Die Antriebselemente sind zwischen den Drahtgruppen mindestens einer der Drahtführungsrollen angeordnet, zwischen denen das Werkstück durch die Anordnung von Drähten zugestellt wird. Es ist nicht nötig, aber auch nicht ausgeschlossen, dass auch die andere, das Drahtgatter aufspannende Drahtführungsrolle ebenfalls mit solchen Antriebselementen versehen sind.

Die Drahtsäge umfasst des Weiteren eine Steuerungseinheit zum Aktivieren der Antriebselemente. Beim Vorliegen einer Fehllage der Schnittspalte einer Drahtgruppe, aktiviert die Steuerungseinheit das Antriebselement, das der Drahtgruppe zugeordnet ist, woraufhin die Drähte dieser Drahtgruppe eine Ausgleichsbewegung vollziehen, die die ermittelte Fehllage der Schnittspalte reduziert oder aufhebt.

Die Steuerungseinheit greift entweder auf Daten zur Fehllage der Schnittspalte zu, die während des Zustellens des Werkstücks mittels einer Messvorrichtung entsprechend der ersten Ausgestaltung des Verfahrens bereitgestellt werden, oder auf drahtsägespezifische Daten, die in einem Datenspeicher abgelegt sind und vor dem Zustellen des Werkstücks entsprechend der zweiten Ausgestaltung des Verfahrens zur Verfügung gestellt werden, oder sowohl auf die einen als auch auf die anderen Daten.

Die Messvorrichtung dient, getrennt für jede Drahtgruppe, zum Ermitteln der Fehllage der Schnittspalte der jeweiligen Drahtgruppe während des Zustellens des Werkstücks durch die Anordnung von Drähten. Die Information zur Fehllage der Schnittspalte der Drahtgruppe wird der Steuerungseinheit übermittelt und dort zu einem Signal (Stellgröße) für die Aktivierung des Antriebselements, das der entsprechenden Drahtgruppe zugeordnet ist, weiterverarbeitet. Die Messvorrichtung und die Steuerungseinheit sind Komponenten eines ersten geschlossenen Regelkreises zur Minimierung der Fehllagen der Schnittspalte. Mittels dieses Regelkreises wird, für jede Drahtgruppe gesondert, das der Drahtgruppe zugeordnete Antriebselement aktiviert und zwar unabhängig von der gegebenenfalls gleichzeitig herbeigeführten Aktivierung eines Antriebselements, das einer anderen der Drahtgruppen zugeordnet ist.

Der Datenspeicher dient zum Vorhalten von Daten zur Aktivierung der Antriebselemente. Die Daten bilden ein drahtsägespezifisches Korrekturprofil ab, und zwar ein eigenes für jede der Drahtgruppen. Ein solches drahtsägespezifisches Korrekturprofil gibt die Richtung und den Betrag der Ausgleichsbewegungen der Drähte der Drahtgruppe in Abhängigkeit der Eindringtiefe der Drähte in das Werkstück vor. Die Steuerungseinheit greift auf diese Daten während des Zustellens des Werkstücks durch die Anordnung von Drähten zu und aktiviert das der jeweiligen Drahtgruppe zugeordnete Antriebselement entsprechend der Vorgaben des für die Drähte dieser Drahtgruppe geltenden drahtsägespezifischen Korrekturprofils. Vorzugsweise sind der Datenspeicher und die Steuerungseinheit Komponenten eines weiteren geschlossenen Regelkreises zur Minimierung der Fehllagen der Schnittspalte.

Verfügt die Drahtsäge über den Datenspeicher, wird vorzugsweise auch eine Recheneinheit zum Verfolgen von Veränderungen eines drahtsägespezifischen Korrekturprofils im Verlauf der Bearbeitung mehrerer Werkstücke bereitgestellt. Beim Erreichen einer festgelegten Schwelle der Veränderungen gibt die Recheneinheit ein Signal zum Einleiten einer vorsorglichen Wartungsmaßnahme aus.

Ein Ausführungsbeispiel zeigt eine Halbleiterscheibe aus einkristallinem Silizium mit einer oberen Seitenfläche und einer unteren Seitenfläche, umfassend
einen warp von weniger als 1,2 µm;
eine Nanotopographie der oberen Seitenfläche, ausgedrückt als THA25 10%, von weniger als 5 nm; und
eine teilflächenbezogene Nanotopographie der oberen Seitenfläche von weniger als 6 nm, ausgedrückt als maximaler peak-to-valley Abstand auf einer Teilfläche und bezogen auf Teilflächen mit einem Flächeninhalt von jeweils 25 mm x 25 mm.

Die Halbleiterscheibe hat vorzugsweise einen Durchmesser von mindestens 200 mm, besonders bevorzugt einen Durchmesser von 300 mm. Die oben angegebenen Eigenschaften der Halbleiterscheibe zu warp, Nanotopographie und flächenbezogene Nanotopographie beziehen sich auf eine Halbleiterscheibe mit einem Durchmesser von 300 mm.

Der warp der Halbleiterscheibe wird entsprechend der Norm SEMI MF 1390-0218 bestimmt.

Zur Untersuchung der Nanotopographie kann ein Interferometer, beispielsweise ein Gerät vom Typ WaferSight^{™} der KLA-Tencor Corp. verwendet werden. Ein solches Interferometer eignet sich zur Messung der Topographie auf der oberen Seitenfläche einer Halbleiterscheibe. Das Gerät bildet eine Höhenkarte der oberen Seitenfläche der Halbleiterscheibe ab, die gefiltert wird und über die ein Analysenfenster mit definierter Analysenfläche bewegt wird. Die Auswertung der Höhenunterschiede im Analysenfenster erfolgt durch THA (threshold height analysis) entsprechend der Normen SEMI M43-0418 und SEMI M78-0618 festgelegten Verfahrensvorschriften. THAXX 10% < 5 nm bedeutet, dass höchstens 10 % der analysierten Fläche der oberen Seitenfläche der Halbleiterscheibe im Analysenfenster mit der durch XX spezifizierten Analysenfläche einen maximalen PV-Abstand (peak-to-valley Metrik) von 5 nm oder größer haben darf. Bei der Halbleiterscheibe beträgt die Nanotopographie der oberen Seitenfläche, ausgedrückt als THA25 10%, weniger als 5 nm, wobei ein Analysenfenster mit kreisförmigen Umfang und einem Durchmesser von 25 mm zur Anwendung kommt und das ungefilterte Topographiesignal mit einem einfachen gaußschen Hoch-Pass-Filter (single Gaussian filter) mit 20 mm Grenzwellenlänge gefiltert wird. Die Grenzwellenlänge schrumpft bis zum Rand der Halbeiterscheibe auf 1 mm. Vor dem Filtern wird ein Randausschluss von 5 mm, nach dem Filtern ein Randausschluss von 15 mm beachtet.

Bei der Messung der Nanotopographie der oberen Seitenfläche kann sich die Halbleiterscheibe im Zustand nach dem Abtrennen vom Werkstück befinden oder in einem Zustand im Anschluss dem Abtrennen nachfolgender Bearbeitungsschritte, wie dem Ätzen und dem Polieren. Vorzugsweise liegt die obere Seitenfläche der Halbleiterscheibe in poliertem Zustand vor.

Die Nanotopographie kann auch teilflächenbezogen ausgewertet werden, also bezogen auf anwenderspezifische Teilflächen (sites) der oberen Seitenfläche der Halbleiterscheibe. Es wird wie vorstehend beschrieben, der PV-Abstand bestimmt (Analysenfenster mit kreisförmigem Umfang und einem Durchmesser von 25 mm, einfacher gaußscher Hochpass-Filter, Grenzwellenlänge 20 mm zum Rand der Halbleiterscheibe hin auf 1 mm schrumpfend). Der Randausschluss beträgt jedoch vor dem Filtern 2 mm und nach dem Filtern 3 mm. Die obere Seitenfläche der Halbleiterscheibe wird in Teilflächen unterteilt, die sich um eine Teilfläche (site) gruppieren, deren linke untere Ecke im Zentrum der oberen Seitenfläche der Halbleiterscheibe angeordnet ist. Bei der Halbleiterscheibe beträgt die teilflächenbezogene Nanotopographie der oberen Seitenfläche weniger als 6 nm, ausgedrückt als maximaler PV-Abstand auf einer Teilfläche und bezogen auf Teilflächen mit einem Flächeninhalt von 25 mm x 25 mm.

Die Erfindung wird nachfolgend unter Bezugnahme auf Zeichnungen weiter erläutert.

### Kurzbeschreibung der Figuren

**Fig. 1** zeigt Hauptmerkmale einer zum Stand der Technik gehörenden Drahtsäge.
**Fig. 2** zeigt Merkmale einer Drahtführungsrolle einer erfindungsgemäßen Drahtsäge.
**Fig.3** zeigt schematisch den Ablauf des erfindungsgemäßen Verfahrens.
**Fig.4** zeigt, wie sich eine tatsächliche Trajektorie durch die Mitte eines Schnittspalts von einer anzustrebenden Trajektorie unterscheiden kann.
**Fig.5** und **Fig.6** zeigen an zwei Beispielen Richtung und Beträge möglicher Ausgleichsbewegungen von Drahtgruppen.
**Fig.7** zeigt ein typisches Korrekturprofil, auf der Grundlage dessen Ausgleichsbewegungen der Drähte einer Drahtgruppe herbeigeführt werden.
**Fig.8** bis **Fig.10** und **Fig.11** bis **Fig.13** zeigen von Medianflächen einer warp-Messung abgeleitete Höhenlinien von jeweils drei Halbleiterscheiben.
**Fig.14** bis **Fig.16** entsprechen **Fig.8** bis **Fig.10** mit dem Unterschied einer höher aufgelösten Skalierung der Ordinate.
Die **Fig.17, 18** und **19** zeigen, wie sich ein drahtsägespezifisches Korrekturprofil im Verlauf der Bearbeitung von mehreren Werkstücken verändern kann.

### Liste der verwendeten Bezugszeichen

- **1**: Sägedraht
- **2**: Rillen
- **3**: linke Drahtführungsrolle
- **4**: rechte Drahtführungsrolle
- **5**: Achse
- **6**: Achse
- **7**: Rotation
- **8**: Drehrichtung
- **9**: Drahtlängsbewegung
- **10**: Drahtlängsbewegung
- **11**: Drahtgatter
- **12**: Zustelleinrichtung
- **13**: Schnittspalt
- **14**: Achse
- **15**: Werkstück
- **16**: Sägeleiste
- **17**: Kleber
- **18**: Pfeilrichtung
- **19**: Düsenkamm
- **20**: Düsenkamm
- **21**: Düsen
- **22**: Strahl
- **23**: Strahl
- **24a-e**: Antriebselement
- **25a-d**: Drahtgruppe
- **26**: Festlager
- **27**: Lager
- **28**: Steuerungseinheit
- **29**: Datenvorgabe
- **30**: Messvorrichtung
- **31**: Datenspeicher
- **32**: anzustrebende Trajektorie

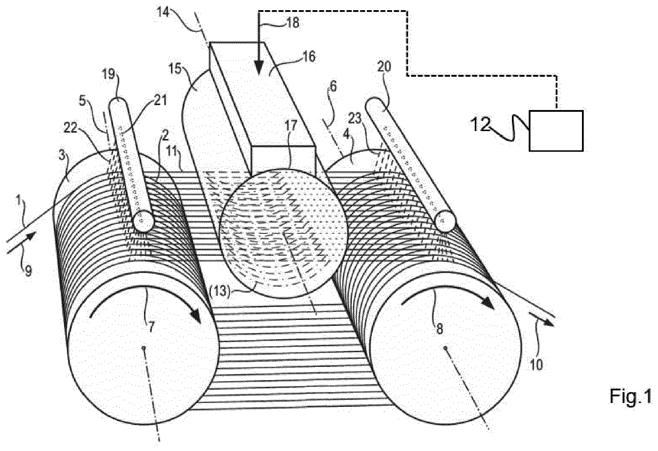

Fig.1 zeigt Hauptmerkmale einer zum Stand der Technik gehörenden Drahtsäge und dient zur Erläuterung von Grundlagen eines Verfahrens zur Herstellung von Halbleiterscheiben aus einem Werkstück durch Bearbeiten des Werkstücks mittels einer Drahtsäge.

Eine geeignete Drahtsäge umfasst Sägedraht 1, der mehrfach spiralförmig um eine linke Drahtführungsrolle 3 und eine rechte Drahtführungsrolle 4 umgelegt und von Rillen 2 so geführt wird, dass die auf der Oberseite der Drahtführungsrollen verlaufenden Drahtabschnitte, die zur Beschreibung der vorliegenden Erfindung als Drähte bezeichnet werden, parallel verlaufen und ein Drahtgatter 11 bilden. Ein Werkstück 15 ist an einer Sägeleiste 16 befestigt, beispielsweise mittels eines Klebers 17 geklebt. Die Sägeleiste 16 wird mit dem Werkstück 15 von einer andeutungsweise dargestellten Zustelleinrichtung 12 in Pfeilrichtung 18 senkrecht gegen das Drahtgatter 11 zugestellt und mit den Drähten des Drahtgatters 11 in Eingriff gebracht. Gegebenenfalls umfasst die Drahtsäge linke Düsenkämme 19 und rechte Düsenkämme 20 mit Düsen 21 zum Zuführen einer Schneidmittel-Suspension in Form eines linken länglichen Strahls 22 und eines rechten länglichen Strahls 23 auf die linke Drahtführungsrolle 3 und die rechte Drahtführungsrolle 4.

Die Drahtführungsrollen sind um Achsen 5 und 6 drehbar gelagert. Ihre Achsen und die Achse 14 des Werkstücks 15 - im gezeigten Beispiel ein zylindrischer Stab - sind parallel zueinander ausgerichtet. Zum Einleiten des Trennvorgangs wird eine Drahtführungsrolle, beispielsweise die linke Drahtführungsrolle 3, zur Rotation 7 angetrieben ("Master"). Die andere Drahtführungsrolle("Slave"), im Beispiel die rechte Drahtführungsrolle 4, dreht sich, durch Draht 1 gezogen, gleichsinnig in Drehrichtung 8 mit. Beim Eingreifen der Drähte in das Werkstück 15 bilden sich Schnittspalte 13.

Üblicherweise wird die Richtung der Drahtlängsbewegung 9, 10 mehrfach während eines vollständigen Schnitts durch das Werkstück 15 umgekehrt, wobei in jedem einzelnen dieser "Pilgerschritt" genannten Paare aus Richtungsumkehrungen der Draht um eine größere Länge in die eine und eine kleinere Länge in die entgegengesetzte Richtung bewegt wird.

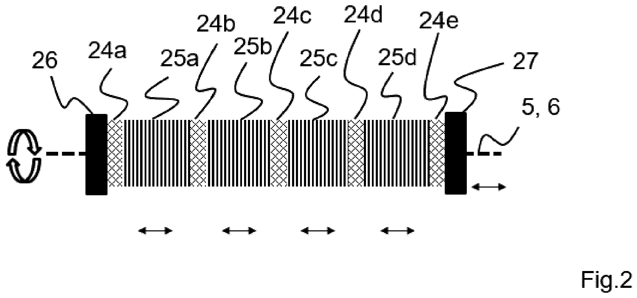

Eine erfindungsgemäße Drahtsäge weist mindestens eine Drahtführungsrolle auf, die Antriebselemente umfasst. Ein Beispiel einer solchen Drahtführungsrolle ist in Fig.2 dargestellt. Bei Aktivierung eines Antriebselements wird eine aktivierte Drahtgruppe in eine Richtung senkrecht zur Laufrichtung der Drähte der Drahtgruppe bewegt. Im dargestellten Beispiel sind fünf Antriebselemente 24a-e und vier Drahtgruppen 25a-d zwischen dem Festlager 26 und dem Lager 27 der Drahtführungsrolle vorgesehen. Das Lager 27 kann als Loslager oder als Festlager ausgeführt sein. Auf das Antriebselement 24e, das an das Lager 27 angrenzt, kann verzichtet werden, falls das Lager 27 ein Loslager ist. Ungeachtet dessen ist das Lager 27 im dargestellten Beispiel als Loslager gezeichnet. Die Doppelpfeile weisen auf mögliche Bewegungsrichtungen hin, in die sich eine Drahtgruppe bewegt, wenn das ihr zugeordnete Antriebselement aktiviert wird. Die Drahtführungsrolle kann in mit Rillen für Drähte versehene Segmente unterteilt sein, die auf einer Welle angeordnet sind, beispielsweise in Segmente, wie sie in JP 11 123 649 A2 beschrieben sind. Ein Antriebselement ist dann zwischen jedem Ende der Segmente und an Festlager angrenzend positioniert. Bei einem derartigen Aufbau verfügt die in Fig.2 dargestellte Drahtführungsrolle über eine Anzahl von Segmenten, die der Anzahl der Drahtgruppen entspricht.

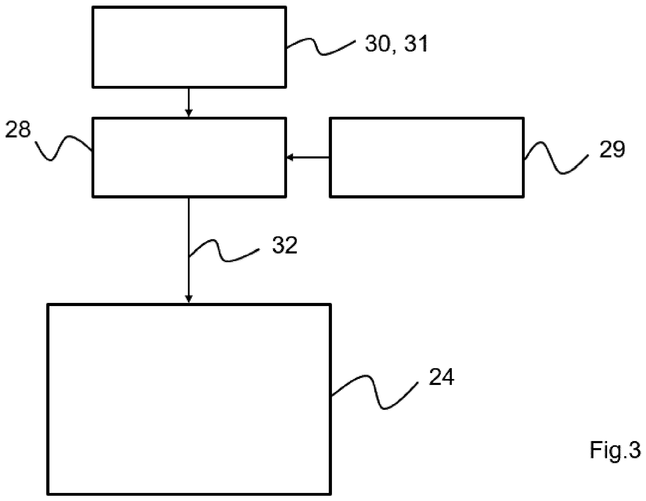

Fig.3 zeigt schematisch den Ablauf, wie eine Steuerungseinheit 28 aufgrund von Daten zu einer Fehllage der Schnittspalte einer Drahtgruppe mit einem Korrektursignal 32 basierend auf einem Korrekturprofil und/oder einem drahtsägespezifischen Korrekturprofil auf Antriebselemente 24 einwirkt, wodurch die Drähte der Drahtgruppen 25 Ausgleichsbewegungen vollziehen. Die Steuerungseinheit 28 erhält den dazu notwendigen Input von einer Messvorrichtung 30 und/oder einem Datenspeicher 31, in dem das drahtsägespezifische Korrekturprofil abgelegt ist.

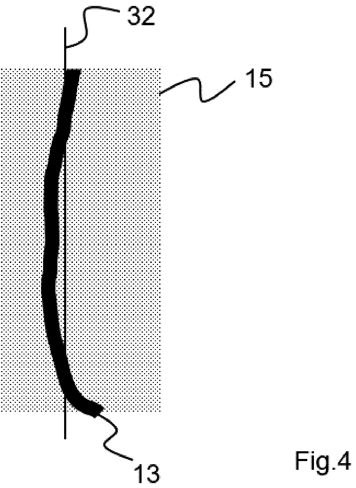

Fig.4 zeigt im Querschnitt ein Bild, das sich entweder durch Beobachten der Schnittspalte oder durch Beobachten der Drähte und des Werkstücks während des Eingriffs der Drähte in das Werkstück gewinnen lässt. Es zeigt einen Teil des Werkstücks 15 und einen Schnittspalt 13, der sich durch das Werkstück erstreckt. Die tatsächliche Trajektorie, die durch die Mitte des Schnittspalts 13 verläuft, weicht während des Entstehens des Schnittspalts mehr oder weniger deutlich von einer anzustrebenden Trajektorie 32 ab. Die Differenz repräsentiert die ermittelte Fehllage des Schnittspalts 13. Wie erwähnt, sieht die Erfindung vor, für jede Drahtgruppe Ausgleichsbewegungen der Drähte der Drahtgruppe in Abhängigkeit der ermittelten Fehllage der Schnittspalte der Drahtgruppe in eine Richtung senkrecht zur Laufrichtung der Drähte der Drahtgruppe herbeizuführen und zwar durch Aktivieren eines Antriebselements, das der jeweiligen Drahtgruppe zugeordnet ist.

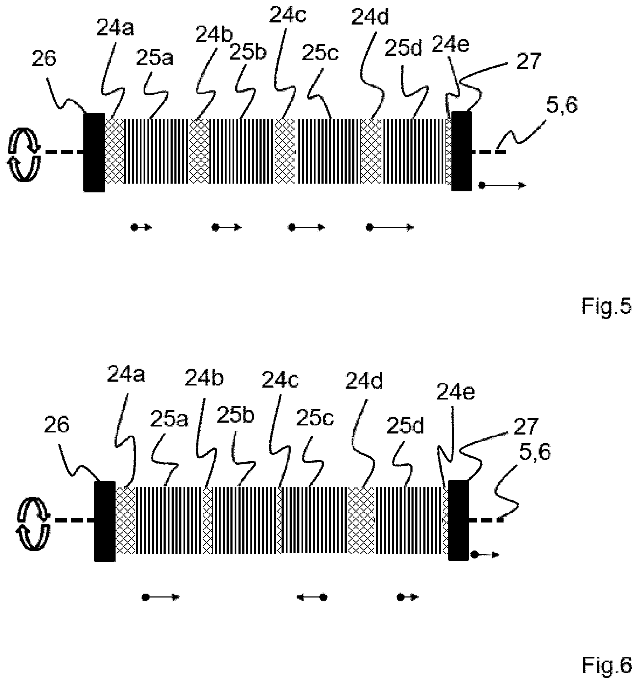

Fig.5 und Fig.6 zeigen an zwei Beispielen Richtung und Beträge möglicher Ausgleichsbewegungen von Drahtgruppen. Die Antriebselemente 24a-e sind beispielsweise piezoelektrische Aktoren. Im Fall von Fig.5 bewirkt die gleichartige Aktivierung der in Fig.2 gezeigten Antriebselemente 24a-d, dass sich die piezoelektrischen Aktoren jeweils um denselben Betrag ausdehnen, so dass die Drahtgruppen 25a-d und das Lager 27 der Drahtführungsrolle dementsprechend vom Festlager 26 wegbewegt werden. Der Betrag der Ausgleichsbewegung steigt, wie es die Pfeile andeuten, von der Drahtgruppe 25a bis zur Drahtgruppe 25d gleichmäßig an. Es kann aber beispielsweise auch erforderlich sein, dass, wie es in Fig.6 dargestellt ist, Ausgleichsbewegungen erforderlich sind, im Zuge derer sich Drahtgruppen gegeneinander bewegen. In Fig.6 ist das Ergebnis zu sehen, wenn die in Fig.2 gezeigten Antriebselemente derart aktiviert werden, dass sich das Antriebselement 24a mit einem Betrag a und das Antriebselement 24d mit einem Betrag d (Betrag d > Betrag a) zum Lager 27 ausdehnen und das Antriebselement 24b mit einem Betrag b und das Antriebselement 24c mit einem Betrag c (Betrag c > Betrag d) zum Festlager 26 schrumpfen. In der Summe ergeben sich dann die mit Pfeilen angedeuteten Ausgleichsbewegungen der Drähte der Drahtgruppen und des Lagers 27: Die Drähte der Drahtgruppe 25a werden mit dem größten Betrag zum Lager 27 bewegt, die Drähte der Drahtgruppe 25b werden nicht bewegt, die Drähte der Drahtgruppe 25c werden mit einem Betrag zum Festlager 26 bewegt und die Drähte der Drahtgruppe 25d mit dem geringsten Betrag zum Lager 27.

Der Vergleich von tatsächlicher Trajektorie und anzustrebender Trajektorie gemäß der ersten Ausgestaltung der Erfindung beziehungsweise der Vergleich von zu erwartender Trajektorie und anzustrebender Trajektorie gemäß der zweiten Ausgestaltung der Erfindung führt zu einer Beschreibung des Verlaufs der Fehllage der Schnittspalte einer Drahtgruppe in Abhängigkeit der Eindringtiefe der Drähte der Drahtgruppe im Werkstück und zu einem Korrekturprofil (erste Ausgestaltung der Erfindung) beziehungsweise zu einem drahtsägespezifischen Korrekturprofil (zweite Ausgestaltung der Erfindung), das komplementär zum Verlauf der Fehllage der Schnittspalte ist.

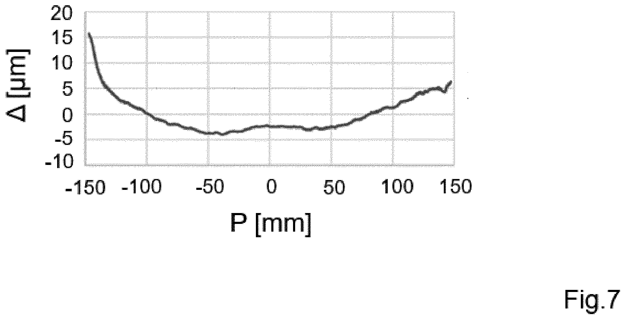

Fig.7 zeigt ein Korrekturprofil, in dem die Abweichung Δ der tatsächlichen Trajektorie von der anzustrebenden Trajektorie in Abhängigkeit der Eindringtiefe P der Drähte der Drahtgruppe aufgetragen ist. Ausgleichsbewegungen der Drähte der Drahtgruppe mit einer Richtung und einem Betrag, der der Abweichung Δ entspricht, werden über eine Aktivierung des der Drahtgruppe zugeordneten Antriebselements herbeigeführt. Nur wenn keine Fehllage der Schnittspalte vorliegt (Δ = 0), was im gezeigten Beispiel zunächst ungefähr bei einer Eindringtiefe von -100 mm der Fall ist, unterbleibt das Herbeiführen solcher Ausgleichsbewegungen.

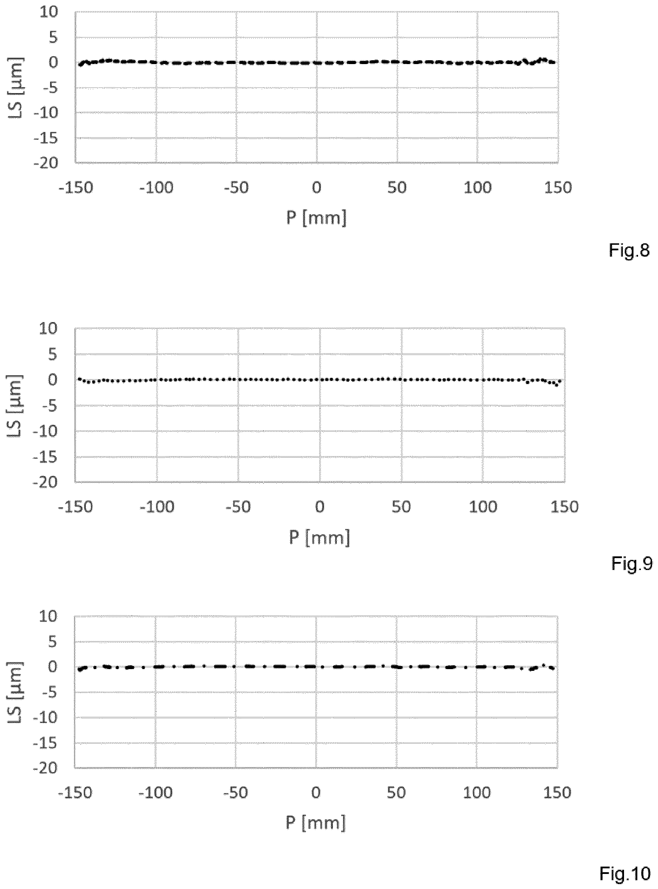

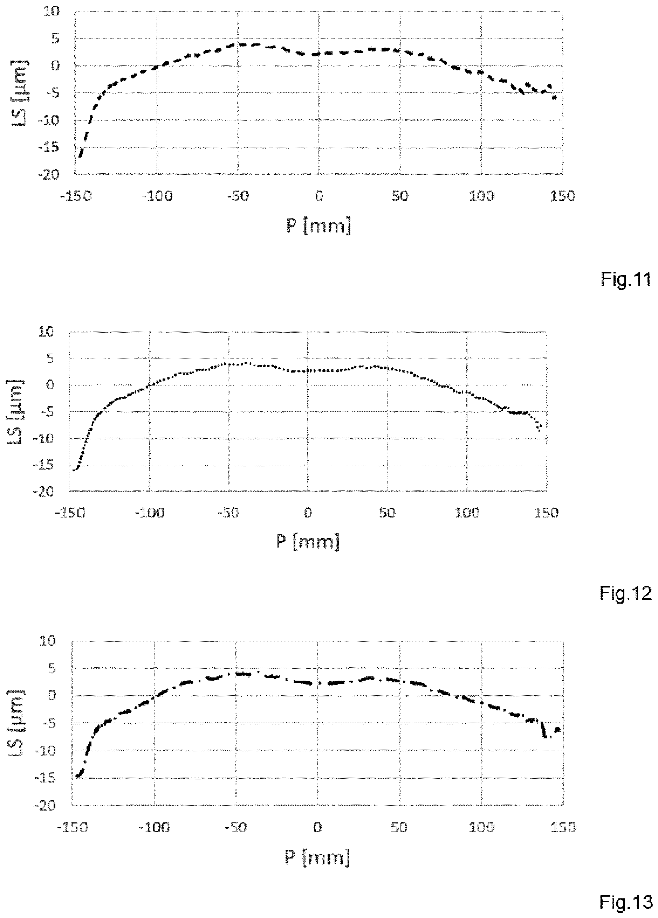

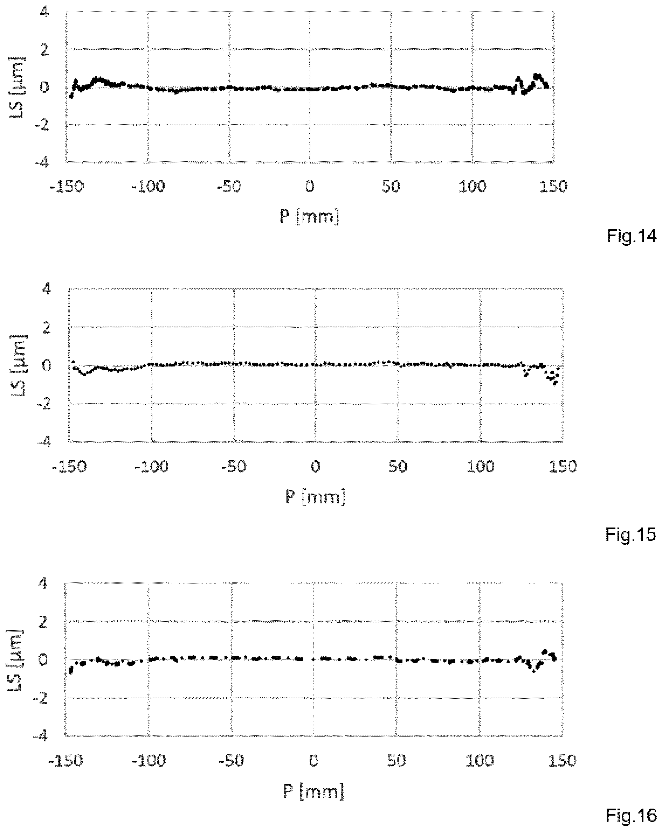

Fig.8 bis Fig.13 zeigen Höhenlinien LS von jeweils drei Halbleiterscheiben, die durch Drähte einer Drahtgruppe von einem Werkstück abgetrennt wurden, wobei während des Abtrennens der Halbleiterscheiben vom Korrekturprofil vorgegebene Ausgleichsbewegungen der Drähte der Drahtgruppe herbeigeführt wurden (Fig.8 bis Fig.10) oder auf das Herbeiführen solcher Ausgleichsbewegungen verzichtet wurde (Fig.11 bis Fig.13). Die Höhenlinien sind jeweils von der Medianfläche einer warp-Messung abgeleitet, wobei Messwerte der Medianfläche selektiert wurden, die auf einer Linie liegen, die dem Durchmesser der jeweiligen Halbleiterscheibe in Richtung des Werkstücks beim Abtrennen der Halbleiterscheibe folgt. Die Position der Halbleiterscheiben im Werkstück war so, dass beim Abtrennen der Halbleiterscheiben zwischen jeder der drei Halbleiterscheiben 50 weitere Halbleiterscheiben entstanden. Wie der Vergleich der Höhenlinien offenlegt, werden Halbleiterscheiben durch Anwendung der Erfindung deutlich ebener und zwar ohne besonderen Einfluss von deren Position im Werkstück. Das bestätigen auch Fig.14 bis Fig.16, die sich von Fig.8 bis Fig. 10 nur dadurch unterscheiden, dass bei ihnen die Skalierung der Ordinate höher aufgelöst ist.

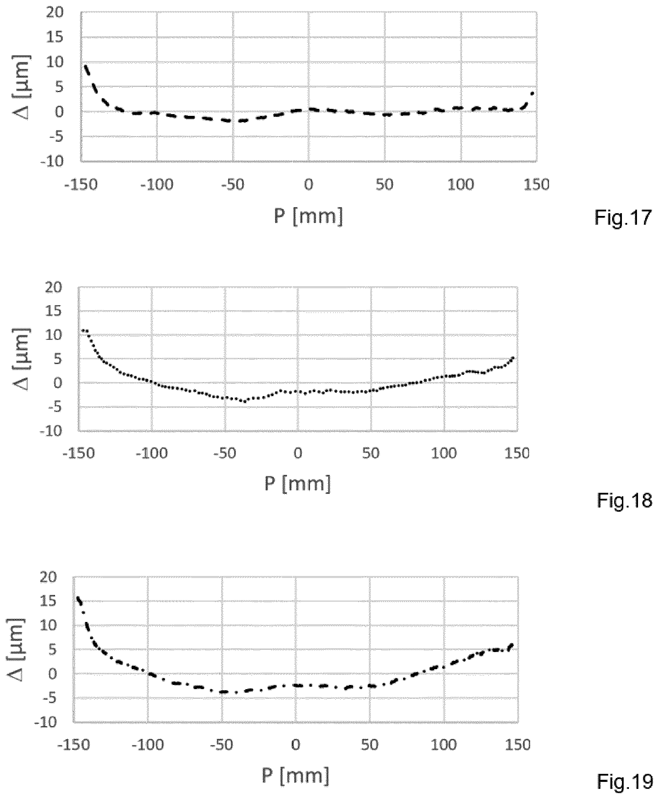

Die Fig.17, 18 und 19 zeigen, wie sich ein drahtsägespezifisches Korrekturprofil im Verlauf der Bearbeitung von mehreren Werkstücken stetig verändern kann. Es ist deshalb vorteilhaft, eine Schwelle für die Abweichung Δ zu definieren, bei deren Überschreiten vorsorgliche Wartungsmaßnahmen eingeleitet werden. Die Schwelle kann beispielsweise so definiert sein, dass erst ein drahtsägespezifisches Korrekturprofil mit einer maximale Abweichung Δₘₐₓ, wie sie in Fig.19 dargestellt ist, zur Folge hat, dass vorsorgliche Wartungsmaßnahmen eingeleitet werden.

Die bezüglich der vorstehend aufgeführten Ausführungsformen des erfindungsgemäßen Verfahrens angegebenen Merkmale können entsprechend auf die erfindungsgemäße Vorrichtung übertragen werden. Umgekehrt können die bezüglich der vorstehend ausgeführten Ausführungsformen der erfindungsgemäßen Vorrichtung angegebenen Merkmale entsprechend auf das erfindungsgemäße Verfahren übertragen werden. Diese und andere Merkmale der erfindungsgemäßen Ausführungsformen werden in der Figurenbeschreibung und in den Ansprüchen erläutert.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren.

Daher sollen alle derartigen Abänderungen und Modifikationen sowie Äquivalente durch den Schutzbereich der Ansprüche abgedeckt sein.

## Patentansprüche

1. Verfahren zur Herstellung von Halbleiterscheiben aus einem Werkstück durch Bearbeiten des Werkstücks mittels einer Drahtsäge, umfassend das Zustellen des Werkstücks durch eine Anordnung von Drähten, die in Drahtgruppen (25a-d) gegliedert zwischen Drahtführungsrollen (3,4) gespannt sind und sich in eine Laufrichtung bewegen;
das Erzeugen von Schnittspalten (13) beim Eingriff der Drähte in das Werkstück;
**gekennzeichnet durch** die Verfahrensschritte:
für jede der Drahtgruppen (25a-d) das Ermitteln einer Fehllage der Schnittspalte der Drahtgruppe; und
für jede der Drahtgruppen das Herbeiführen von Ausgleichsbewegungen der Drähte der Drahtgruppe in Abhängigkeit der ermittelten Fehllage der Schnittspalte der Drahtgruppe in eine Richtung senkrecht zur Laufrichtung der Drähte der Drahtgruppe (25a-d)
während des Zustellens des Werkstücks durch die Anordnung von Drähten durch Aktivieren mindestens eines Antriebselements (24a-e).

2. Verfahren nach Anspruch 1, umfassend das Gliedern der Drähte in nicht weniger als drei Drahtgruppen (25a-d) und höchstens einer Anzahl von Drahtgruppen, die der Anzahl der Drähte der Anordnung entspricht.

3. Verfahren nach Anspruch 1 oder Anspruch 2, umfassend das Ermitteln der Fehllage der Schnittspalte (13) während des Zustellens des Werkstücks durch die Anordnung von Drähten.

4. Verfahren nach einem der Ansprüche 1 bis 3, umfassend das Ermitteln der Fehllage der Schnittspalte (13) der Drahtgruppe (25a-d) durch Messen der Position der Schnittspalte der Drahtgruppe mittels Bestrahlung der Schnittspalte der Drahtgruppe mit optischer Strahlung, IR-Strahlung, Röntgen-Strahlung oder γ-Strahlung, durch mechanische Abtastung der Schnittspalte oder durch induktive oder kapazitive Messung der Schnittspalte (13), und Vergleichen der gemessenen Position mit einer Soll-Position der Schnittspalte (13).

5. Verfahren nach einem der Ansprüche 1 bis 3, umfassend das Ermitteln der Fehllage der Schnittspalte (13) der Drahtgruppe (25a-d) durch zeitgleiches Messen der Position der Drähte der Drahtgruppe und des Werkstücks relativ zu einem feststehenden Bezugspunkt mittels Bestrahlung mit optischer Strahlung, IR-Strahlung, Röntgen-Strahlung oder γ-Strahlung, mittels kapazitiver oder induktiver Messung oder mittels mechanischer Abtastung, und Vergleichen der gemessenen Position mit einer jeweiligen Soll-Position.

6. Verfahren nach einem der Ansprüche 1 bis 5, umfassend das Verfolgen von Veränderungen eines drahtsägespezifischen Korrekturprofils im Verlauf der Bearbeitung mehrerer Werkstücke und das Einleiten einer vorsorglichen Wartungsmaßnahme, falls die Veränderungen eine festgelegte Schwelle erreicht haben.

7. Verfahren nach Anspruch 6, umfassend das Ermitteln der Fehllage der Schnittspalte durch Messen der lokalen Geometrie von Halbleiterscheiben, die zuvor mittels der Drahtsäge hergestellt wurden, zum Erstellen des drahtsägespezifischen Korrekturprofils.

8. Drahtsäge zur Herstellung von Halbleiterscheiben durch Bearbeiten eines Werkstücks, umfassend Drahtführungsrollen (3,4), zwischen denen Drähte zu einer Anordnung von Drähten gespannt sind, die in Drahtgruppen (25a-d) gegliedert sind und sich in eine Laufrichtung bewegen;
eine Zustelleinrichtung zum Zustellen des Werkstücks durch die Anordnung von Drähten unter Erzeugen von Schnittspalten (13) beim Eingriff der Drähte in das Werkstück;
**gekennzeichnet durch** Antriebselemente (24a-e), von denen mindestens eines einer jeden der Drahtgruppen (25a-d) zugeordnet ist, zum Bewegen der Drähte der zugeordneten Drahtgruppe; und
eine Steuerungseinheit zum Aktivieren der Antriebselemente, wobei die Steuerungseinheit beim Vorliegen einer Fehllage der Schnittspalte (13) der Drahtgruppen (25a-d) dasjenige Antriebselement (24a-e) aktiviert, welches der Drahtgruppe zugeordnet ist, wodurch die Drähte dieser Drahtgruppe Ausgleichsbewegungen senkrecht zur Laufrichtung ausführen.

9. Drahtsäge nach Anspruch 8, umfassend eine Messvorrichtung zum Ermitteln der Fehllage der Schnittspalte (13) der jeweiligen Drahtgruppe (25a-d) während des Zustellens des Werkstücks, wobei die Messvorrichtung und die Steuerungseinheit Bestandteil eines geschlossenen Regelkreises sind.

10. Drahtsäge nach Anspruch 8, umfassend einen Datenspeicher, in dem für die Drähte einer jeden der Drahtgruppen (25a-d) ein drahtsägespezifisches Korrekturprofil abgespeichert ist, auf das die Steuerungseinheit zum Aktivieren der Antriebselemente während des Zustellens des Werkstücks zugreift.

11. Drahtsäge nach Anspruch 10, umfassend eine Einheit zum Verfolgen von Veränderungen des drahtsägespezifischen Korrekturprofils im Verlauf der Bearbeitung mehrerer Werkstücke, und zur Ausgabe eines Signals zum Einleiten einer vorsorglichen Wartungsmaßnahme, falls die Veränderungen eine festgelegte Schwelle erreicht haben.

## Claims

1. Method for producing semiconductor wafers from a workpiece by processing the workpiece by means of a wire saw, comprising
feeding the workpiece through an arrangement of wires which are tensioned between wire guide rollers (3, 4) while being divided into wire groups (25a-d) and move in a running direction;
producing kerfs (13) when the wires engage into the workpiece;
**characterized by** the following method steps:
for each of the wire groups (25a-d), determining a placement error of the kerfs of the wire group; and
for each of the wire groups, inducing compensating movements of the wires of the wire group as a function of the determined placement error of the kerfs of the wire group in a direction perpendicular to the running direction of the wires of the wire group (25a-d) during the feeding of the workpiece through the arrangement of wires by activating at least one drive element (24a-e).

2. Method according to Claim 1, comprising dividing the wires into no fewer than three wire groups (25a-d) and at most a number of wire groups which corresponds to the number of wires of the arrangement.

3. Method according to Claim 1 or Claim 2, comprising determining the placement error of the kerfs (13) during the feeding of the workpiece through the arrangement of wires.

4. Method according to one of Claims 1 to 3, comprising determining the placement error of the kerfs (13) of the wire group (25a-d) by measuring the position of the kerfs of the wire group by means of irradiating the kerfs of the wire group with optical radiation, IR radiation, X-radiation or γ radiation, by mechanical sensing of the kerfs or by inductive or capacitive measurement of the kerfs (13), and comparing the measured position with a setpoint position of the kerfs (13).

5. Method according to one of Claims 1 to 3, comprising determining the placement error of the kerfs (13) of the wire group (25a-d) by simultaneously measuring the position of the wires of the wire group and of the workpiece relative to a fixed reference point by means of irradiation with optical radiation, IR radiation, X-radiation or γ radiation, by capacitive or inductive measurement or by mechanical sensing, and comparing the measured position with a respective setpoint position.

6. Method according to one of Claims 1 to 5, comprising tracking changes in a wire saw-specific correction profile in the course of the processing of a plurality of workpieces, and initiating a precautionary maintenance measure if the changes have reached an established threshold.

7. Method according to Claim 6, comprising determining the placement error of the kerfs by measuring the local geometry of semiconductor wafers which have been produced beforehand by means of the wire saw, in order to compile the wire saw-specific correction profile.

8. Wire saw for producing semiconductor wafers by processing a workpiece, comprising
wire guide rollers (3, 4), between which wires are tensioned to form an arrangement of wires, which are divided into wire groups (25a-d) and move in a running direction;
a feed device for feeding the workpiece through the arrangement of wires while producing kerfs (13) when the wires engage into the workpiece;
**characterized by** drive elements (24a-e), at least one of which is assigned to each of the wire groups (25a-d), for moving the wires of the assigned wire group; and
a control unit for activating the drive elements, the control unit, when there is a placement error of the kerfs (13) of the wire groups (25a-d), activating that drive element (24a-e) which is assigned to the wire group, so that the wires of this wire group execute compensating movements perpendicularly to the running direction.

9. Wire saw according to Claim 8, comprising a measuring apparatus for determining the placement error of the kerfs (13) of the respective wire group (25a-d) during the feeding of the workpiece, the measuring apparatus and the control unit being part of a closed control loop.

10. Wire saw according to Claim 8, comprising a data memory in which a wire saw-specific correction profile is stored for the wires of each of the wire groups (25a-d), and which the control unit accesses in order to activate the drive elements during the feeding of the workpiece.

11. Wire saw according to Claim 10, comprising a unit for tracking changes in the wire saw-specific correction profile in the course of the processing of a plurality of workpieces, and for outputting a signal for initiating a precautionary maintenance measure if the changes have reached an established threshold.

## Revendications

1. Procédé de fabrication des plaquettes de semi-conducteur à partir d'une pièce par traitement de la pièce à l'aide d'une scie à fil, ledit procédé comprenant les étapes suivantes
amener la pièce à travers un ensemble de fils qui sont divisés en groupes de fils (25a-d) et qui sont tendus entre des rouleaux de guidage de fil (3, 4) et se déplacent dans un sens de défilement ;
générer des espaces de coupe (13) lorsque les fils s'engagent dans la pièce ;
**caractérisé par** les étapes de procédé suivantes :
pour chacun des groupes de fils (25a-d), déterminer une position incorrecte de l'espace de coupe du groupe de fils ; et
pour chacun des groupes de fils, provoquer des mouvements de compensation des fils du groupe de fils en fonction de la position incorrecte déterminée de l'espace de coupe du groupe de fils dans une direction perpendiculaire au sens de défilement des fils du groupe de fils (25a -d)
pendant l'amenée de la pièce à travers l'ensemble de fils, activer au moins un élément d'entraînement (24a-e).

2. Procédé selon la revendication 1, comprenant la division des fils en au moins trois groupes de fils (25a-d) et au plus en un nombre de groupes de fils qui correspond au nombre de fils de l'ensemble.

3. Procédé selon la revendication 1 ou la revendication 2, comprenant la détermination de la position incorrecte de l'espace de coupe (13) lors de l'amenée de la pièce à travers l'ensemble des fils.

4. Procédé selon l'une des revendications 1 à 3, comprenant les étapes suivantes
déterminer la position incorrecte de l'espace de coupe (13) du groupe de fils (25a-d) par mesure de la position de l'espace de coupe du groupe de fils par irradiation de l'espace de coupe du groupe de fils avec un rayonnement optique, un rayonnement IR, un rayonnement X ou un rayonnement y, par balayage mécanique de l'espace de coupe ou par mesure inductive ou capacitive de l'espace de coupe (13), et
comparer la position mesurée à une position cible de l'espace de coupe (13).

5. Procédé selon l'une des revendications 1 à 3, comprenant les étapes suivantes
déterminer la position incorrecte de l'espace de coupe (13) du groupe de fils (25a-d) par mesure simultanée de la position des fils du groupe de fils et de la pièce par rapport à un point de référence fixe par irradiation avec un rayonnement optique, un rayonnement IR, un rayonnement X ou un rayonnement y, par mesure capacitive ou inductive ou par balayage mécanique, et
comparer la position mesurée à une position cible respective.

6. Procédé selon l'une des revendications 1 à 5, comprenant les étapes suivantes
suivre les variations d'un profil de correction spécifique à une scie à fil au cours du traitement de plusieurs pièces et
déclencher une mesure de maintenance préventive si les variations ont atteint un seuil déterminé.

7. Procédé selon la revendication 6, comprenant l'étape suivante
déterminer la position incorrecte de l'espace de coupe par mesure de la géométrie locale de plaquettes de semi-conducteur, qui ont été préalablement fabriquées à l'aide de la scie à fil, pour créer le profil de correction spécifique à la scie à fil.

8. Scie à fil destinée à la fabrication de plaquettes de semi-conducteur par traitement d'une pièce, ladite scie à fil comprenant
des rouleaux de guidage de fil (3, 4) entre lesquels des fils sont tendus pour former un ensemble de fils qui sont divisés en groupes de fils (25a-d) et se déplacent dans un sens de défilement ;
un module d'amenée destiné à amener la pièce à travers l'ensemble de fils pour créer des espaces de coupe (13) lorsque les fils s'engagent dans la pièce ; **caractérisée par**
des éléments d'entraînement (24a-e), dont l'un au moins est associé à chacun des groupes de fils (25a-d) pour déplacer les fils du groupe de fils associé ; et
une unité de commande destinée à activer les éléments d'entraînement,
en présence d'une position incorrecte de l'espace de coupe (13) des groupes de fils (25a-d), l'unité de commande activant l'élément d'entraînement (24a-e) qui est associé au groupe de fils, de sorte que les fils de ce groupe de fils effectuent des mouvements de compensation perpendiculairement au sens de défilement.

9. Scie à fil selon la revendication 8, comprenant un dispositif de mesure destiné à déterminer la position incorrecte de l'espace de coupe (13) du groupe de fils respectif (25a-d) lors de l'amenée de la pièce, le dispositif de mesure et l'unité de commande faisant partie d'une boucle de régulation fermée.

10. Scie à fil selon la revendication 8, comprenant une mémoire de données dans laquelle est mémorisé, pour les fils de chacun des groupes de fils (25a-d), un profil de correction spécifique à la scie à fil auquel l'unité de commande accède pour activer les éléments d'entraînement pendant l'amenée de la pièce.

11. Scie à fil selon la revendication 10, comprenant une unité destinée à suivre des variations du profil de correction spécifique à la scie à fil au cours du traitement de plusieurs pièces, et à émettre un signal destiné à déclencher une mesure de maintenance préventive si les variations ont atteint un seuil déterminé.
